# EUROPÄISCHE PATENTSCHRIFT

(11) **EP 0 544 193 B1**
(45) Veröffentlichungstag und Bekanntmachung des Hinweises auf die Patenterteilung: **10.08.1994**
(21) Anmeldenummer: 92119785.1
(22) Anmeldetag: 20.11.1992
(51) Int. Cl.: H03F 3/217, H03F 1/52

(54) **Differentialschutzeinrichtung für einen modularen Verstärker**
Differential protective device for a modular amplifier
Dispositif de déclenchement différentiel pour un amplificateur modulair

(30) Priorität: 27.11.1991 DE 4138960
(43) Veröffentlichungstag der Anmeldung: 02.06.1993
(73) Patentinhaber: TELEFUNKEN Sendertechnik GmbH, 10553 Berlin (DE)
(72) Erfinder: Vitters, Hans-Heinrich, Dipl.-Ing., W-1000 Berlin 37 (DE); Volmering, Helmut, Dipl.-Ing., W-1000 Berlin 61 (DE)
(74) Vertreter: Salhoff, Roland, Dipl.-Ing.

(56) Entgegenhaltungen:
- WO-A-88/00772
- US-A- 3 211 927
- US-A- 3 629 685
- US-A- 5 014 153

## Beschreibung

Die Erfindung betrifft eine Differentialschutzeinrichtung für einen modularen Verstärker gemäß dem Oberbegriff des Anspruchs 1.

Differentialschutzeinrichtungen für Transformatoren, auch für Transformatoren mit mehr als einer Sekundärwicklung, sind bereits bekannt. Dabei wird der Primär- und der Sekundärstrom des Transformators in einem Abschaltgerät miteinander verglichen, ausgewertet und der Transformator in Abhängigkeit von dem Ergebnis des Stromvergleiches erforderlichenfalls abgeschaltet. In den bekannten Differentialschutzeinrichtungen sind an der Primärwicklung und an jeder einzelnen Sekundärwicklung des Transformators Stromwandler erforderlich.

Bei Anwendung dieser bekannten Differentialschutzeinrichtung in einem modularen Verstärker, der einen Transformator mit mehreren Sekundärwicklungen aufweist, aus denen einzelne, ausgangsseitig in Reihe geschaltete, Verstärkermodule gespeist sind, ist für jeden einzelnen sekundärseitigen Stromwandler und für die Meßkabel eine elektrische Isolation erforderlich, die auf die Gesamtausgangsspannung des Verstärkers ausgelegt sein muß. Als Beispiel für einen vorangehend beschriebenen Verstärker sei auf einen Modulations-Leistungsverstärker für anodenmodulierte Rundfunksender hingewiesen.

Der Erfindung liegt die Aufgabe zugrunde für einen modular aufgebauten Verstärker, dessen transformatorisch gespeiste Verstärkermodule ausgangsseitig in Reihe geschaltet sind, eine Differentialschutzeinrichtung mit einem geringen Geräte- und Montageaufwand bezüglich der Meßwerterfassungseinrichtungen zu schaffen.

Diese Aufgabe wird erfindungsgemäß durch die im Kennzeichen des Anspruchs 1 angegebenen Merkmale gelöst. Weiterbildungen sind in den Unteransprüchen angegeben.

Die Erfindung hat den Vorteil, daß für einen vorangehend beschriebenen modularen Verstärker der meßtechnische Aufwand zur Erfassung eines Kurzschlusses in einer der Sekundärwicklungen des Transformators oder in den Zuleitungen von den Sekundärwicklungen zu den Verstärkermodulen sehr gering ist. Es ist dazu auf der Sekundärseite des Trafos nur ein Gleichstromwandler und ein Meßspannungsteiler erforderlich. Mit der erfindungsgemäßen Einsparung von darüberhinausgehenden sekundärseitigen Meßstellen wird neben den Meßstellen selbst zugleich der hohe Aufwand für die elektrische Isolation dieser Meßstellen und Zuleitungen vermieden. In den Unteransprüchen sind weitere Möglichkeiten für Vereinfachungen der Meßwerterfassungen aufgezeigt, die einmal für die primärseitige Meßwerterfassung vorteilhaft die Tatsache ausnutzen, daß die Netzspannung im allgemeinen relativ stabil ist und die zum anderen für den Fall, daß der Verstärker mit einem konstanten Lastwiderstand beaufschlagt ist, einen ausgangsseitigen Meßspannungsteiler erübrigen. Die momentane Ausgangsleistung wird bei dieser Lösungsvariante mittels eines Multiplikationsproduktes ermittelt, dessen Faktoren der gemessene und ins Quadrat erhobene Ausgangsstrom und ein fest vorgegebener Wert für den Lastwiderstand sind. Außerdem ist in den Unteransprüchen eine Lösung angegeben, in welcher die erfindungsgemäße Differentialschutzeinrichtung vorteilhaft durch ein zusätzliches Abschaltkriterium ergänzt ist, das auf die Detektion eines Brummsignales beruht, das bei ein- oder zweiphasigen sekundärseitigen Kurzschlüssen am primärseitigen Strommeßkreis des Drehstromtransforamtors auftritt.

Anhand der Zeichnung sind zwei Ausführungsbeispiele der Erfindung näher erläutert.
- Fig. 1: zeigt eine erfindungsgemäße Differentialschutzeinrichtung an einem modularen Verstärker, die mit einer Zusatzeinrichtung zur Auswertung von phasenverschobenen Primärströmen des Transformators ausgerüstet ist und
- Fig. 2: zeigt eine Differentialschutzeinrichtung gemäß Fig. 1 mit demgegenüber vereinfachter Meßwerterfassung.

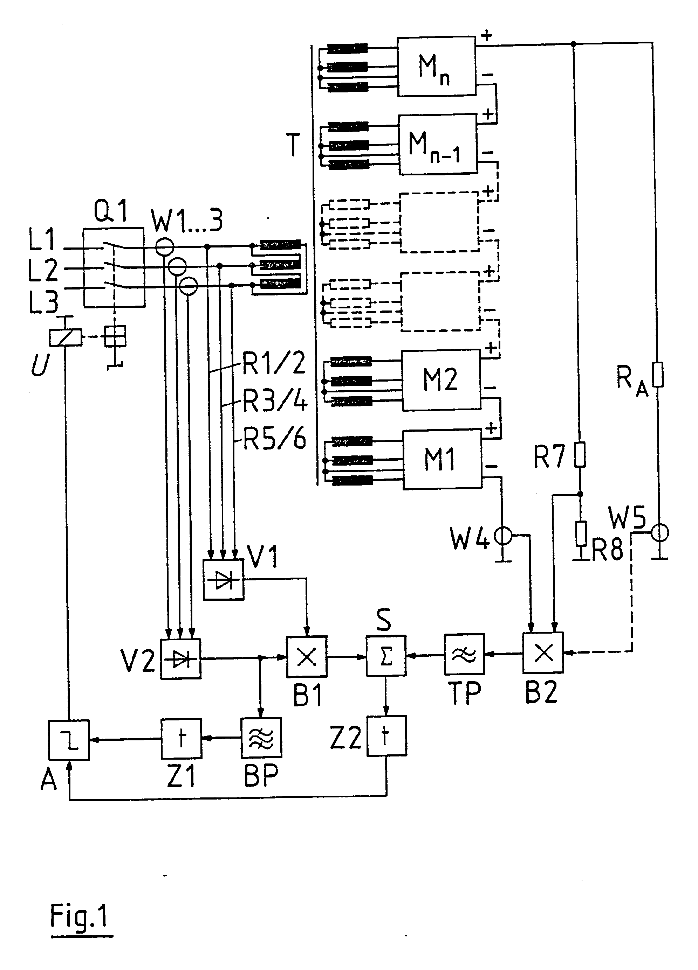

Der in Fig. 1 gezeigte Verstärker besteht aus einem Drehstromtransformator T, mehreren Verstärkermodulen M1,..., Mₙ, primärseitigen Zuleitungen L1, L2, L3, einem Leistungsschalter Q1 mit einem Auslöser U, vier Meßspannungsteilern R1/R2, R3/R4, R5/R6, R7/R8 und drei Stromwandlern W1, W2, W3, aus Meßgleichrichtern V1, V2, einem Gleichstromwandler W4, zwei Multiplizierern B1, B2, einem Summierer S, einem Tiefpaß TP, zwei Zeitgliedern Z1, Z2, einem Bandpaß BP und aus einem Abschaltgerät A.

Der Drehstromtransformator T ist z. B. mit einer im Dreieck geschalteten Primärwicklung und mit n Stück im Stern geschalteten Sekundärwicklungen ausgeführt. In den primärseitigen Zuleitungen L1, L2, L3 zu dem Drehstromtransformator T ist der dreiphasige Leistungsschalter Q1 integriert. An jede Sekundärwicklung des Drehstromtransformators T ist ein Verstärkermodul M1, M2,..., Mₙ₋₁, Mₙ angeschlossen. Die Ausgänge der Module sind in Reihe geschaltet. Mit dem negativen Pol seines Verstärkermodules M1 liegt der Verstärkerausgang an Masse. Am positiven Pol des Verstärkermodules Mₙ steht die Gesamtausgangsspannung aller hintereinandergeschalteter Verstärkermodule M1, M2, ..., Mₙ₋₁, Mₙ an. Der Verstärker ist mit einem Lastwiderstand R_{A} beaufschlagt, der mit dem positiven Pol des Verstärkermodules Mₙ verbunden ist.

Die Meßspannungsteiler R1/R2, R3/R4, R5/R6 und die Stromwandler W1, W2, W3 sind in die primärseitigen Zuleitungen L1, L2, L3 integriert und führen ihre Meßsignale nach Gleichrichtung in den Meßgleichrichtern V1, V2 dem Multiplizierer B1 zur Ermittlung der momentanen Eingangsleistung des Verstärkers zu, die der Primärleistung des Drehstromtransformators T entspricht. Der Gleichstromwandler W4 ist in den ausgangsseitigen Masseanschluß des Verstärkermodules M1 integriert. Mit gleicher Wirkung kann dieser Wandler alternativ zu der gezeigten Anordnung auch an jeder beliebigen anderen Stelle in den Lastkreis des Verstärkers integriert sein, solange wie er dabei nur den gesamten Ausgangsstrom des Verstärkers erfaßt. In der Zeichnung ist beispielhaft dazu ein alternativ angeordneter Gleichstromwandler W5 mit strichpunktierter Verbindungsleitung gezeigt. Der Meßspannungsteiler R7/R8 ist so in den Verstärkerausgang integriert, daß über ihn die Gesamtausgangsspannung des Verstärkers abfällt, d. h. er liegt parallel zum Lastwiderstand R_{A}. Der Gleichstromwandler W4 und der Meßspannungsteiler R7/R8 führt sein Meßsignal auf den Multiplizierer B2 zur Ermittlung der momentanen Ausgangsleistung des Verstärkers. Im Multiplizierer B2 wird eine der Ausgangsleitung des Verstärkers proportionale Spannung gewonnen.

Ausgangsseitige Lastwechseländerungen am Lastwiderstand R_{A} treten auf der Primärseite des Transformators mit einer Verzögerung auf, die durch die Laufzeit der Gleichrichter-Siebkette in den Verstärkermodulen M1, M2,..., Mₙ, bestimmt ist. Zum Ausgleich dieser Verzögerung wird das im Multiplizierer B2 gewonnene Meßsignal auf den Tiefpaß TP gegeben, der so dimensioniert ist, daß er in seiner Laufzeit der Gleichrichter-Siebkette entspricht. Damit wird eine Lastwechseländerung dem Summierer S mit dem primär- und dem sekundärseitigen Meßsignal zeitgleich gemeldet. Am Ausgang des Summierers S erscheint im ungestörten Verstärkerbetrieb ein der Verlustleistung des Verstärkers entsprechendes kleines Differenzsignal.

Wird nun auf der Sekundärseite des Drehstromtransformators T eine Wicklung oder ein Leitersystem kurzgeschlossen, so tritt nur auf der Primärseite des Transformators eine wesentlich erhöhte Leistungsaufnahme auf, die über die Meßspannungsteiler R1/R2, R3/R4, R5/R6, den Stromwandlern W1, W2, W3 und den Meßgleichrichtern V1, V2 von dem Multiplizierer B1 erfaßt wird. Am Ausgang des Summierers S wird dadurch ein Differenzsignal mit einem hohem Pegel erzeugt.

Ebenso entsteht beim Einschalten des Verstärkers für eine Zeitdauer von einigen 100 ms am Ausgang des Gleichrichters V2 ein erhebliches Signal. Damit sich dieses "Einschaltsignal" in der Schutzeinrichtung nicht auswirkt, ist dem dem Summierer S das Zeitglied Z2 nachgeschaltet. In diesem Zeitglied wird ein Differenzsignal des Summierers S nicht weitergeschaltet, wenn es nicht über eine vorgegebene Zeitdauer in dem Zeitglied Z2 angestanden hat. Das Zeitglied Z2 kann z. B. als Schalter ausgeführt sein, der von einer Kondensatoraufladung zeitgesteuert ist und erst bei Erreichen einer bestimmten Kondensatorladespannung durchschaltet. Fällt das Ausgangssignal am Summierer S vorher ab, d. h. daß es auf den immer anstehenden Durchgangsverlustwert des Verstärkers sinkt, dann wird auch der Ladevorgang des Kondensators automatisch abgebrochen.

Der Ausgang des Zeitgliedes Z2 ist auf ein Abschaltgerät A geführt, in dem ein Abschaltsignal generiert wird, wenn ein durch das Zeitglied Z2 passiertes Differenzsignal des Summieres S eine bestimmte vorgebbare Pegelhöhe überschreitet. Dieses Abschaltsignal wirkt auf den Auslöser U des Leistungsschalters Q1 ein und schaltet damit den Verstärker ab.

Wird auf der Sekundärseite des Drehstromtransformators T eine Wicklung gegen den Neutralleiter oder werden zwei Wicklungen gegeneinander kurzgeschlossen, so tritt am Ausgang des Gleichrichters V2 ein hohes Brummsignal auf, das als zusätzliches Abschaltkriterium genutzt werden kann. Bei einem 50 Hz-Netz beträgt die Frequenz des Brummsignales 100 Hz; bei einem 60 Hz-Netz entsprechend 120 Hz. Das Ausgangssignal des Gleichrichters V2 ist auf den Bandpaß BP gegeben, der Frequenzen im Bereich von 80 Hz bis 140 Hz durchläßt. Dem Bandpaß BP ist das Zeitglied Z1 nachgeschaltet, das den Einschalt-Rush des Drehstromtransformators T unterdrückt und entsprechend dem vorangehend beschriebenen Zeitglied Z2 funktioniert, das dem Summierer S nachgeschaltet ist. Ein von dem Zeitglied Z1 ausgegebenes Brummsingal führt im Abschaltgerät A zu der Generierung eines Abschaltsignales. Diese Generierung erfolgt unabhängig von der Auswertung des vom Summierer S ausgegebenen Differenzsignales.

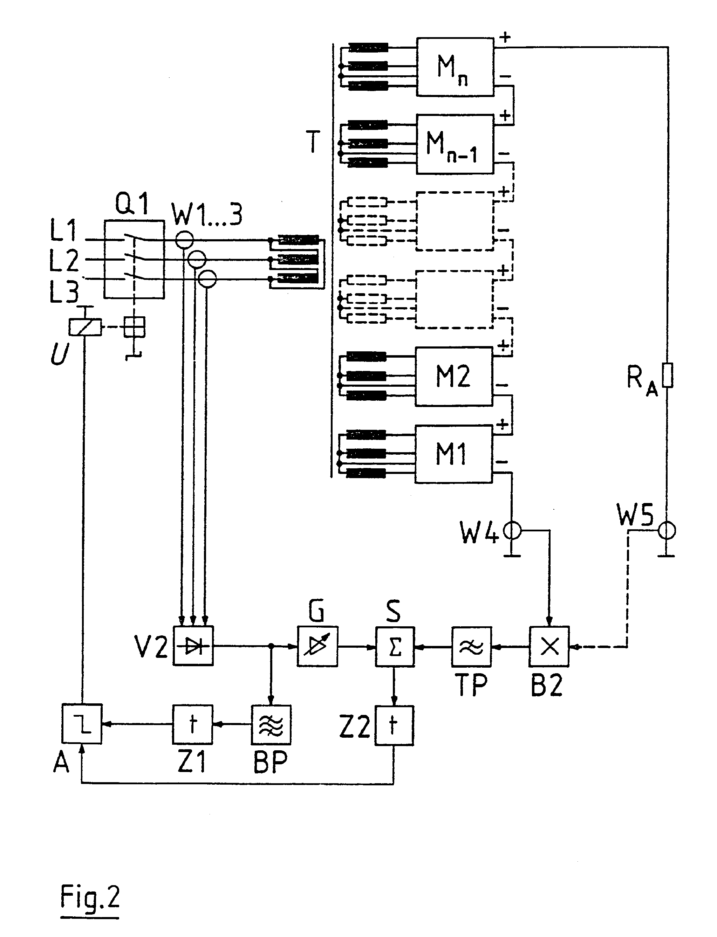

Die in dem Ausführungsbeispiel der Fig. 2 gezeigte vereinfachte Meßwerterfassung für die vorangehend beschriebene Differentialschutzeinrichtung läßt eine mögliche Netzspannungsschwankung unberücksichtigt, da die Neztspannung im allgemeinen relativ stabil ist. Dadurch kann der Aufwand für die eingangseitigen Meßspannungsteiler R1/R2, R3/R4, R5/R6, den Multiplizierer B1 und den Meßgleichrichter V1 vermieden werden. Die Primärleistung des Verstärkers wird in diesem Fall nur aus dem gemessenen Eingangsstrom ermittelt, indem das von dem Meßgleichrichter V2 abgegebene Spannungssignal der Stromwandler W1, W2, W3 in einem nachgeschalteten Pegelverstärker G mit einem Faktor beaufschlagt und daran dem Summierer S zugeführt ist.

Eine weiterer Beitrag zu der Vereinfachung der Meßwerterfassung ist gemäß Fig. 2 dadurch gegeben, daß auf den ausgangsseitigen Meßspannungsteiler R7/R8 verzichtet ist. Der Lastwiderstand R_{A} kann in engen Grenzen als konstant angesehen werden, wenn es sich dabei um den Außenwiderstand eines Rundfunksendermodulators handelt. Die Ausgangsleistung des Verstärkers ist in dem gezeigten Beispiel allein aus der Messung des Ausgangsstromes ermittelt, indem im Multiplizierer das Produkt I² R_{A} gebildet ist, wobei die Größe R_{A} als konstanter Wert in den Multiplizierer B2 eingespeichert ist.

## Patentansprüche

1. Differentialschutzeinrichtung für einen modularen Verstärker, der einen Transformator mit mehreren Sekundärwicklungen aufweist, aus denen einzelne ausgangsseitig in Reihe geschaltete Verstärkermodule gespeist sind, mit Stromwandlern für die Erfassung von Eingangs- und Ausgangsströmen, mit einem Abschaltgerät, das bei kritischen Differenzwerten zwischen den Eingangs- und Ausgangsströmen auf einen Leistungsschalter zum Zwecke des Abschaltens des Verstärkers einwirkt, dadurch gekennzeichnet, daß die momentane Eingangsleistung des Verstärkers aus den mittels Stromwandlern (W1, W2, W3), Meßspannungsteilern (R1/R2, R3/R4, R5/R6) und Meßgleichrichtern (V1, V2) gemessenen Primärströmen und -spannungen des Transformators (T) in einem Multiplizierer (B1) ermittelt ist, daß von dem Multiplizierer (B1) ein der ermittelten Eingangsleistung proportionales Spannungssignal ausgegeben ist, daß die momentane Ausgangsleistung des Verstärkers aus dem mittels eines Gleichstromwandlers (W4) gemessenen Ausgangsstrom, der über die Verstärkermodule (M1,...,Mₙ) fließt und aus der an einem Meßspannungsteiler (R7/R8) gemessenen Gesamtausgangsspannung, die über den in Reihe geschalteten Verstärkermodulen (M1,..., Mₙ) anliegt, in einem Multiplizierer (B2) ermittelt ist, daß von dem Multiplizierer (B2) ein der ermittelten Ausgangsleistung proportionales Spannungssignal ausgegeben ist, daß dieses ausgegebene Spannungssignal einen Tiefpaß (TP) mit der gleichen Laufzeit wie die Gleichrichter-Siebkette der Verstärkermodule (M1,..., Mₙ) durchläuft, daß in einem Summierer (S) die Differenz der aus dem eingangsseitigem Multipizierer (B1) und aus dem Tiefpaß (TP) abgegebenen Spannungssignale gebildet ist, daß das Differenzsignal des Summierers (S) auf ein Zeitglied (Z2) gegeben ist, welches das Differenzsignal nur ausgibt, wenn es über eine vorgegebene Zeitdauer in dem Zeitglied (Z2) angestanden hat, und daß ein aus dem Zeitglied (Z2) ausgegebenes Differenzsignal auf ein Abschaltgerät (A) gegeben ist, in dem bei Überschreitung einer vorgegebenen Pegelhöhe des Differenzsignales ein Abschaltsignal generiert ist, das zum Zwecke des Abschaltens des Verstärkers auf einen Leistungsschalter (Q1) einwirkt, der in die primärseitigen Zuleitungen (L1, L2, L3) des Transformators (T) integriert ist.

2. Differentialschutzeinrichtung nach Anspruch 1, dadurch gekennzeichnet, daß die momentane Eingangsleistung des Verstärkers nur aus einer Messung der Primärströme ermittelt ist, indem anstelle von gemessenen Primärspannungen das von dem Meßgleichrichter (V2) der Stromwandler (W1, W2, W3) abgebebene Spannungssignal in einem nachgeschalteten Pegelverstärker (G) mit einem konstanden Faktor beaufschlagt und daran anschließend dem Summierer (S) zugeführt ist.

3. Differentialschutzeinrichtung nach Anspruch 1 oder 2, dadurch gekennzeichnet, daß für einen Verstärkereinsatz an einem konstanten Lastwiderstand (R_{A}) die momentane Ausgangsleistung nur aus einer Messung des Ausgangsstromes ermittelt ist, indem in dem Multiplizierer (B2) das Produkt I² R_{A} gebildet ist.

4. Differentialschutzeinrichtung nach einem der Ansprüche 1 bis 3, dadurch gekennzeichnet, daß das aus dem eingangsseitigem Gleichrichter (V2) abgegebene Spannungssignal parallel zu dem Summierer (S) auf einen Bandpaß (BP) gegeben ist, der nur Signale mit Frequenzen in dem Bereich von 80 Hz bis 140 Hz durchläßt, daß der Ausgang des Bandpasses (BP) mit einem Zeitglied (Z1) verbunden ist, welches ein Ausgangssignal des Bandpasses nur dann weiterleitet, wenn dieses Signal über eine vorgegebene Zeitdauer in dem Zeitglied (Z1) angestanden hat und daß ein aus dem Zeitglied (Z1) ausgegebenes Signal auf das Abschaltgerät (A) gegeben ist, das bei Anliegen eines Bandpaßsignales den Verstärker über den Leistungsschalter (Q1) abschaltet.

## Claims

1. Differential protective device for a modular amplifier which comprises a transformer with several secondary windings, from which individual amplifier modules connected in series at the output are fed, with current transformers for the detection of input and output currents, with a disconnecting device which in the case of critical difference values between the input and output currents acts on a circuit breaker for the purpose of switching the amplifier off, characterised thereby, that the momentary input power of the amplifier is ascertained in a multiplier (B1) from the primary currents and voltages of the transformer (T), which are measured by means of current transformers (W1, W2, W3), measurement voltage dividers (R1/R2, R3/R4, R5/R6) and measurement rectifiers (V1, V2), that a voltage signal proportional to the ascertained input power is delivered by the multiplier (B1), that the momentary output power of the amplifier is ascertained in a multiplier (B2) from the output current, which flows by way of the amplifier modules (M1 to Mn) and is measured by means of a direct current transformer (W4), and from the total output voltage, which is present across the amplifier modules (M1 to Mn) connected in series and which is measured at a measurement voltage divider (R7, R8), that a voltage signal proportional to the ascertained output power is delivered by the multiplier (B2), that this delivered output signal passes through a low-pass filter (TP) of the same transit time as the rectifier filter chain of the amplifier modules (M1 to Mn), that the difference between the voltage signals delivered by the multiplier (B1) at the input side and by the low-pass filter (TP) is formed in a summator (S), that the difference signal of the summator (S) is applied to a timing member (Z2), which delivers the difference signal only when it has been present in the timing member (Z2) for a preset time span and that a difference signal delivered by the timing member (Z2) is applied to a disconnecting device (A), in which a disconnecting signal, which for the purpose of the disconnection of the amplifier acts on a circuit breaker (Q1), which is integrated into the primary feed lines (L1, L2, L3) of the transformer (T), is generated when the difference signal exceeds a preset level.

2. Differential protective device according to claim 1, characterised, thereby, that the momentary input power of the amplifier is ascertained only from a measurement of the primary currents in that, in the place of measured primary voltages, the voltage signal delivered by the measurement rectifier (V2) of the current transformers (W1, W2, W3) is loaded by a constant factor, in a level amplifier (G) connected therebehind and subsequently thereto fed to the summator (S).

3. Differential protective device according to claim 1 or 2, characterised thereby, that for an amplifier use across a constant load resistance (R_{A}), the momentary output power is ascertained only from a measurement of the output current in that the product I².R_{A} is formed in the multiplier (B2).

4. Differential protective device according to one of the claims 1 to 3, characterised thereby, that the voltage signal delivered by the measurement rectifier (V2) at the input side is applied in parallel with the summator (S) to a band-pass filter (BP), which passes only signals of frequencies in the range of 80 to 140 hertz, that the output of the band-pass filter (BP) is connected with a timing member (Z1), which passes an output signal of the band-pass filter (BP) on only when this signal has been present in the timing member (Z1) for a preset time span and that a signal delivered by the timing member (Z1) is applied to the disconnecting device (A), which in the presence of a band-pass signal switches the amplifier off by way of the circuit breaker (Q1).

## Revendications

1. Dispositif de protection différentielle pour un amplificateur modulaire, comprenant un transformateur avec plusieurs enroulements secondaires à partir desquels sont alimentés des modules d'amplificateur individuels, connectés en série par leurs sorties, des transformateurs d'intensité pour déterminer des courants d'entrée et de sortie, ainsi qu'un appareil de coupure qui, lorsqu'apparaissent des différences critiques entre les courants d'entrée et de sortie, agit sur un interrupteur de puissance afin d'arrêter l'amplificateur, caractérisé en ce que la puissance d'entrée instantanée de l'amplificateur est déterminée dans un multiplicateur (B1) à partir des courants et tensions primaires du transformateur (T), mesurés au moyen de transformateurs d'intensité (W1, W2, W3), de diviseurs de tension de mesure (R1/R2, R3/R4, R5/R6) et de redresseurs de mesure (V1, V2), que le multiplicateur (B1) délivre un signal de tension proportionnel à la puissance d'entrée déterminée, que la puissance de sortie instantanée de l'amplificateur est déterminée dans un multiplicateur (B2) à partir du courant de sortie, circulant par les modules d'amplificateur (M1,..., Mn) et mesuré au moyen d'un convertisseur continu-continu (W4), et à partir de la tension de sortie totale, appliquée aux bornes des modules d'amplificateur (M1,...,Mn) connectés en série, et mesurée sur un diviseur de tension de mesure (R7/R8), que le multiplicateur (B2) délivre un signal de tension proportionnel à la puissance de sortie déterminée, que ce signal de sortie délivré passe par un filtre passe-bas (TP) ayant le même temps de propagation que le redresseur-filtre en échelle des modules d'amplificateur (M1,...,Mn), que la différence entre les signaux de tension délivrés par le multiplicateur (B1) prévu du côté de l'entrée et par le filtre basse-pas (TP) est formée dans un totalisateur (S), que le signal de différence du totalisateur (S) est appliqué à un élément de retard (Z2) qui délivre le signal de différence seulement s'il a été appliqué dans cet élément de retard (Z2) au-delà d'une durée préfixée, et qu'un signal de différence délivré par l'élément de retard (Z2) est transmis à un appareil de coupure (A) dans lequel, au cas où le signal de différence dépasse un niveau préfixé, est généré un signal de coupure qui, en vue de l'arrêt de l'amplificateur, agit sur un interrupteur de puissance (Q1) intégré dans les lignes d'arrivée côté primaire (L1, L2, L3) du transformateur (T).

2. Dispositif de protection différentielle selon la revendication 1, caractérisé en ce que la puissance d'entrée instantanée de l'amplificateur est déterminée seulement à partir d'une mesure des courants primaires, du fait que, à la place de tensions primaires mesurées, le signal de tension, délivré par le redresseur de mesure (V2), des transformateurs d'intensité (W1, W2, W3), est affecté d'un facteur constant dans un amplificateur de niveau (G) monté à la suite et est envoyé après cela au totalisateur (S).

3. Dispositif de protection différentielle selon la revendication 1 ou 2, caractérisé en ce que, pour une utilisation de l'amplificateur sur une résistance de charge (RA) constante, la puissance de sortie instantanée est déterminée seulement à partir d'une mesure du courant de sortie, du fait que le produit I²R_{A} est formé dans le multiplicateur (B2).

4. Dispositif de protection différentielle selon une des revendications 1 à 3, caractérisé en ce que le signal de tension délivré par le redresseur (V2) côté entrée, est appliqué parallèlement au totalisateur (S) et à un filtre passe-bande (BP) qui laisse seulement passer des signaux dont les fréquences sont comprises dans le domaine de 80 HZ à 140 Hz, que la sortie du filtre passe-bande (BP) est reliée à un élément de retard (Z1) qui retransmet un signal de sortie du filtre passe-bande seulement au cas où ce signal a été appliqué dans l'élément de retard (Z1) pendant une durée préfixée, et qu'un signal délivré par l'élément de retard (Z1) est transmis à l'appareil de coupure (A) qui, en cas d'application d'un signal venant du filtre passe-bande, arrête l'amplificateur au moyen de l'interrupteur de puissance (Q1).
